Europäisches Patentamt

European Patent Office

Office européen des brevets

(11) Numéro de publication: **0 093 038**

A1

(12) **DEMANDE DE BREVET EUROPEEN**

(21) Numéro de dépôt: **83400762.7**

(22) Date de dépôt: **18.04.83**

(51) Int. Cl.³: **H 01 L 41/18**

(30) Priorité: **27.04.82 FR 8207257**

(43) Date de publication de la demande:
**02.11.83 Bulletin 83/44**

(84) Etats contractants désignés:
**DE GB IT NL SE**

(71) Demandeur: THOMSON-CSF
173, Boulevard Haussmann
F-75379 Paris Cedex 08(FR)

(72) Inventeur: Broussoux, Dominique
THOMSON-CSF SCPI 173, bld Haussmann
F-75379 Paris Cedex 08(FR)

(72) Inventeur: Leonard, Claudie
THOMSON-CSF SCPI 173, bld Haussmann
F-75379 Paris Cedex 08(FR)

(72) Inventeur: Micheron, François
THOMSON-CSF SCPI 173, bld Haussmann
F-75379 Paris Cedex 08(FR)

(72) Inventeur: Servet, Bernard
THOMSON-CSF SCPI 173, bld Haussmann
F-75379 Paris Cedex 08(FR)

(74) Mandataire: Lepercque, Jean et al,
THOMSON-CSF SCPI 173, Bld Haussmann
F-75379 Paris Cedex 08(FR)

(54) **Matériaux polymères piézoélectriques.**

(57) L'invention se rapporte aux matériaux polymères piézoélectriques et notamment aux alliages $PVF_2$ - PMMA.

L'invention a pour objet des alliages de polymères dont
certaines compositions permettent d'obtenir directement la
phase polaire β lors de la cristallisation à pression ambiante,
ou permettent l'obtention de coefficients piézoélectriques g
plus élevés que pour les polymères employés seuls ainsi que
de pertes diélectriques plus faibles.

L'invention s'applique aux transducteurs électromécaniques comportant une élément actif en polymère piézolétrique.

EP 0 093 038 A1

./...

# FIG.1

## MATERIAUX POLYMERES PIEZOELECTRIQUES

La présente invention se rapporte à des alliages de polymères piézoélectriques. Plus précisément, elle a trait aux alliages de polyfluorure de vinylidène (PVF$_2$) et de polyméthacrylate de méthyle (PMMA) pour lesquels certaines compositions permettent d'obtenir directement la phase polaire lors de la cristallisation à pression ambiante. Certaines compositions permettent l'obtention de coefficients piézoélectriques g plus élevés que ceux du PVF$_2$ employé seul ainsi que des pertes diélectriques plus faibles.

Parmi les polymères piézoélectriques, l'un des plus employés est le polyfluorure de vinylidène (PVF$_2$) qui ne donne pas naissance à une phase polaire par simple cristallisation. On confère à ce matériau des propriétés piézoélectriques par deux traitements successifs ou simultanés. Ces deux traitements consistent à exercer, à une température d'environ 70° C, une traction pour obtenir des allongements irréversibles pouvant atteindre 300 à 500 %, ce qui transforme en phase polarisable la phase initiale et à orienter cette phase sous l'action d'un champ électrique intense. Cette manière de procéder est gênante dans certains cas, par exemple lorsque des transducteurs polymères sont obtenus par moulage ou injection, et où il serait souhaitable de pouvoir obtenir directement la phase polarisable sans avoir à modifier la forme géométrique du transducteur.

Pour pallier cet inconvénient, il est connu d'obtenir la phase cristalline β , qui est la phase polarisable, à la cristallisation en adoptant des copolymères de PVF$_2$ : on peut citer les copolymères PVF$_2$ - PTrFE (polytri-fluoroéthylène) et PVF$_2$ - PTFE (polytétrafluoroéthylène). Un inconvénient majeur des copolymères est qu'ils sont obtenus par polymérisation d'un mélange des monomères constituants et que cette opération est du ressort du fabricant. D'autre part, si les coefficients piézoélectriques ont été améliorés dans la famille des copolymères PVF$_2$ - PTrFE par rapport au PVF$_2$, les pertes diélectriques n'ont pas diminué de façon sensible.

Afin de pallier ces inconvénients, l'invention propose des alliages de polymères piézoélectriques avec des compositions permettant d'obtenir directement la phase polarisable dès la cristallisation ; certaines de ces compositions permettent en outre d'obtenir de meilleurs coefficients piézoélectriques et des pertes diélectriques moindres. Ainsi l'utilisateur des polymères de base peut aisément réaliser l'alliage.

L'invention a donc pour objet un matériau présentant une phase polaire lorsqu'il se refroidit à pression ambiante à partir de l'état fondu, caractérisé en ce qu'il est un alliage d'au moins un premier et un second polymère ; ledit premier polymère étant un polymère piézoélectrique dépourvu de phase polaire lorsqu'il se refroidit à pression ambiante à partir de l'état fondu ; ledit second polymère coopérant avec le premier polymère afin d'engendrer ladite phase polaire.

L'invention sera mieux comprise au moyen de la description ci-après et des figures annexées parmi lesquelles :

- la figure 1 est un diagramme représentant la proportion des phases cristallines et le taux de cristallinité en fonction des concentrations en constituants d'un alliage ;

- la figure 2 est un diagramme qui représente la variation de la constante diélectrique $\varepsilon r$ en fonction de la fréquence pour différents alliages ;

- la figure 3 est un diagramme qui représente la variation des pertes diélectriques tg $\delta$ en fonction de la fréquence pour différents alliages.

Les matériaux polymères peuvent se classer en deux groupes principaux, d'une part les polymères amorphes, d'autre part les polymères semi-cristallins. Un exemple de polymères semi-cristallins est le polyfluorure de vinylidène ($PVF_2$). La structure du polyfluorure de vinylidène se compose de zones cristallines sphéroïdales contenues dans une phase amorphe. Les propriétés mécaniques macroscopiques sont celles d'un corps isotrope. Ce polymère présente des formes cristallines distinctes : $\alpha$ et $\beta$. La forme $\alpha$ est celle que l'on obtient à partir du polymère fondu à une température de l'ordre de 170° C ou après évaporation, à une température supérieure à 80° C, d'une solution de $PVF_2$ dans un solvant qui peut être par exemple le diméthyl-formamide (DMF). Dans le cas du $PVF_2$, les chaînes moléculaires s'enroulent en hélice et présentent un agencement des atomes de carbone, d'hydrogène et de fluor, tel que les moments électriques dipolaires se compensent l'un l'autre lorsque l'on progresse le long de la chaîne. La forme $\beta$, qui est une phase fortement polaire, est moins stable que la forme $\alpha$ qui

caractérise la phase non polaire. Elle est caractérisée par une chaîne moléculaire en zigzag et par des moments électriques dipolaires dont les effets s'ajoutent. Dans ce cas, si on considère un petit élément volumique du matériau polymère, cet élément comprend donc un certain nombre de chaînes représentant une phase solide fortement polaire. La phase $\beta$ peut être induite par étirement du matériau et est susceptible d'être orientée électriquement. Il est également possible d'obtenir partiellement une phase polaire $\alpha_p$ par la seule application d'un champ électrique très intense (supérieur à 1 MV/cm) à température supérieure ou égale à la température ambiante.

On a remarqué que certains alliages de polymères dont l'un au moins est un polymère piézoélectrique peuvent présenter une phase $\beta$ directement lors de leur solidification sans qu'il soit besoin d'exercer une quelconque action mécanique sur les produits réalisés à partir de ces alliages. La différence entre alliages et copolymères tient à ce que les premiers sont obtenus par mélange (en solution ou en phase fondues) des polymères constituants alors que les seconds sont obtenus par polymérisation du mélange des monomères constituants. Les opérations d'alliages peuvent être réalisées par l'utilisateur de polymères.

Néanmoins, tous les alliages entre polymères ne sont pas possibles. Pour qu'un alliage soit réalisable, il faut qu'il y ait compatibilité entre les polymères constituants sinon il se produit un phénomène de démixion. La compatibilité de deux polymères pour former un matériau peut se définir comme l'obtention d'un polymère "intermédiaire" entre ses deux constituants. Cet aspect "intermédiaire" est observé par exemple sur la transition vitreuse. Il y a compatibilité lorsque la transition vitreuse est unique et que sa température est une fonction linéaire de la concentration d'un des constituants. Dans la majorité des cas d'alliages, on n'observe la compatibilité que dans une gamme limitée de concentrations.

On va s'intéresser plus particulièrement au cas des alliages de $PVF_2$ avec le polyméthacrylate de méthyle (PMMA), à l'étude de leurs phases cristallines et de leurs propriétés piézoélectriques.

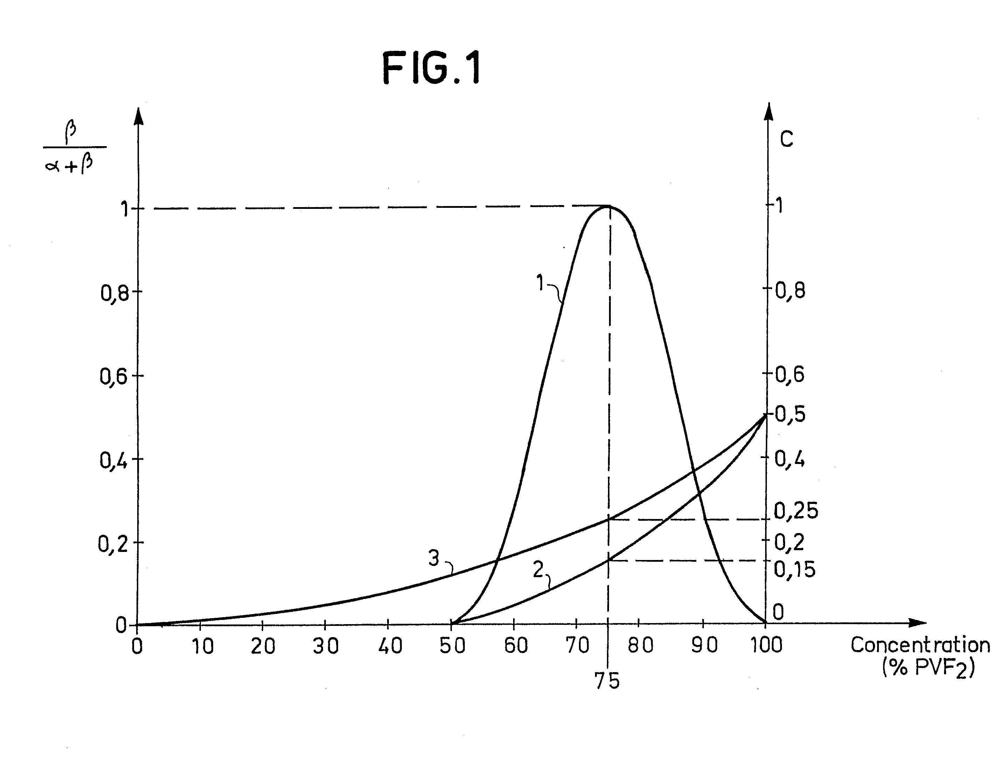

La figure 1 est un diagramme qui se rapporte à l'étude des phases cristallines d'un alliage $PVF_2$ - PMMA. L'abscisse de ce diagramme représente la concentration en poids de $PVF_2$ dans l'alliage considéré. L'ordonnée dressée à partir de 0 % de $PVF_2$ représente le rapport $\frac{\beta}{\alpha + \beta}$ qui est la proportion de la phase cristalline $\beta$ rapportée à l'ensemble des phases $\alpha$ et $\beta$. L'ordonnée dressée à partir de 100° % de $PVF_2$ dans l'alliage représente le taux de cristallinité. L'étude des différentes concentrations de $PVF_2$ dans l'alliage $PVF_2$ - PMMA a donné les résultats suivants :

- pour une concentration de $PVF_2$ inférieure à 50 % en poids, l'alliage est amorphe après refroidissement à partir de la fusion (environ 200° C),

- pour une concentration supérieure à 50 %, il est semi-cristallin.

L'observation des phases cristallines est effectuée par diffraction des rayons X et absorption infra-rouge. La courbe 1 représente le rapport $\frac{\beta}{\alpha + \beta}$ en fonction de la concentration en poids de $PVF_2$ dans l'alliage. Cette courbe a une allure vaguement en cloche avec un maximum pour environ 75 % de $PVF_2$. De 0 à 50 % de $PVF_2$, l'alliage est amorphe donc le rapport $\frac{\beta}{\alpha + \beta}$ est nul. Ce rapport redevient nul pour le $PVF_2$ pur (100 % de concentration). On constate que pour la concentration 75 %, l'alliage cristallise seulement en phase polaire $\beta$ alors que la phase la plus stable de $PVF_2$ est la phase non polaire $\alpha$. Le rapport $\frac{\beta}{\alpha + \beta}$ passe donc par un maximum égal à 1.

La courbe 2 représente le taux de cristallinité C qui est le rapport des éléments de l'alliage possèdant une phase cristalline $\alpha$ ou $\beta$ à l'ensemble de l'alliage qui comprend des éléments possédant une phase amorphe. On constate que le taux de cristallinité C augmente régulièrement de 0 à 0,5 entre les concentrations 50 et 100 %. Ce taux de cristallinité peut être notablement augmenté par recuit, soit typiquement à environ 120° C pendant 2 heures, les proportions relatives des phases en présence restant inchangées. C'est ce que représente la courbe 3 qui montre une progression régulière du taux de cristallinité C de 0 à 100 % de $PVF_2$. Pour le $PVF_2$ pur C est le même avant ou après recuit. Pour l'alliage le plus intéressant, c'est-à-dire celui qui présente la plus grande polarisabilité (environ 75 % de $PVF_2$), ce recuit fait passer le taux de cristallinité d'environ 0,15 à 0,25.

On va maintenant étudier les propriétés diélectriques et piézoélectriques des alliages $PVF_2$ - PMMA et les comparer au $PVF_2$ seul.

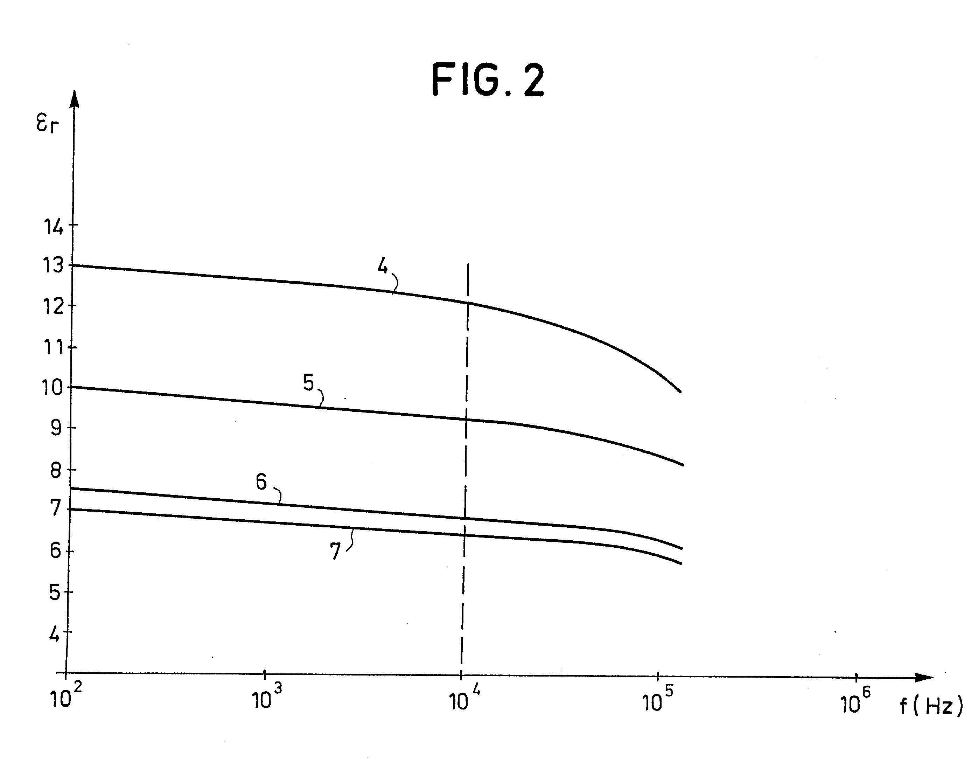

La figure 2 représente la variation à température ambiante de la constante diélectrique relative $\varepsilon r$ en fonction de la fréquence pour différentes compositions. Le $PVF_2$ utilisé est commercialisé sous la marque SOLVAY 1010. La courbe 4 a été tracée pour le $PVF_2$ pur, la courbe 5 pour un alliage de 90 % de $PVF_2$ et 10 % de PMMA en poids (90 $PVF_2$ 10 PMMA), la courbe 6 pour 75 % de $PVF_2$ et la courbe 7 pour 70 % de $PVF_2$. On constate que $\varepsilon r$ décroît lentement avec la fréquence et plus sensiblement avec le pourcentage de $PVF_2$ dans l'alliage. Pour une fréquence f = 10 kHz, pour les différentes compositions envisagées, $\varepsilon r$ prend les valeurs 12 pour le $PVF_2$ pur, 9 pour 90 % de $PVF_2$, 6,7 pour 75 % de $PVF_2$ et 6,2 pour 70 % de $PVF_2$.

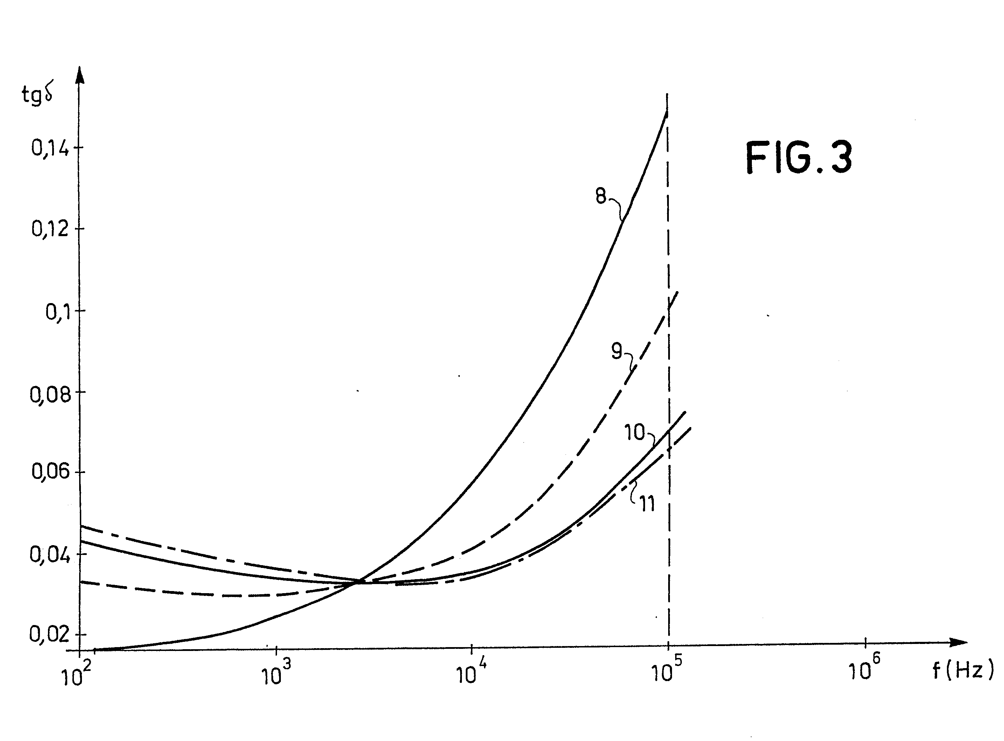

La figure 3 représente les pertes diélectriques des différentes compositions. Les courbes de la figure 3 montrent la variation à température ambiante des pertes diélectriques représentées par tg $\delta$ en fonction de la fréquence pour les mêmes compositions que précédemment. La courbe 8 a été tracée pour le $PVF_2$ pur. On constate que les pertes augmentent régulièrement avec la fréquence. Les courbes 9, 10 et 11 ont été tracées pour des compositions comprenant respectivement 90, 75 et 70 % de $PVF_2$. On constate que, pour des fréquences supérieures à environ 10 kHz, les pertes diélectriques sont moins élevées lorsque le pourcentage en poids de $PVF_2$ dans l'alliage diminue. Ces résultats sont la conséquence de la remontée en température de la transition vitreuse. En effet, le PMMA a sa transition à 105° C tandis que le $PVF_2$ l'a à - 40° C (en statique). Un accroissement en poids de PMMA dans l'alliage a donc pour effet d'augmenter la température de transition. Pour un alliage 70 $PVF_2$ 30 PMMA, la transition se situe autour de 70° C. Pour une fréquence de 100 kHz, on relève sur le diagramme de la figure 3, tg $\delta$ = 0,15 pour 100 % de $PVF_2$, 0,102 pour 90 % de $PVF_2$, 0,07 pour 75 % et 0,066 pour 70 % de $PVF_2$.

Lorsque des films de différents alliages $PVF_2$ - PMMA sont polarisés à 80° C suivant une direction 3 perpendiculaire au plan des films pendant 1 heure sous 300 kV/cm sans avoir été étirés, on obtient les coefficients $d_{33}$ suivants :

| alliages | $d_{33}$ |
|---|---|
| 100 PVF$_2$ (phase $\alpha$) | 3 à 4 pCN$^{-1}$ |
| 90 PVF$_2$ 10 PMMA | 4 à 5 pCN$^{-1}$ |
| 75 PVF$_2$ 25 PMMA | 6 à 7 pCN$^{-1}$ |
| 50 PVF$_2$ 50 PMMA | 1 à 2 pCN$^{-1}$ |

D'après ce tableau, on constate que la valeur maximale de $d_{33}$ correspond à 75 % de PVF$_2$ dans l'alliage ce qui revient à la présence exclusive de la phase β dans l'alliage. Pour le PVF$_2$ pur, le champ électrique de polarisation tend à convertir très partiellement la phase β en phase pseudo-polaire $^{\alpha}$p.

Les alliages PVF$_2$ - PMMA peuvent aussi subir une effet mécanique tel que ceux qui contribuent à développer une phase polarisable dans le PVF$_2$ pur. Lorsque les alliages PVF$_2$ - PMMA sont laminés et polarisés simultanément dans les conditions suivantes :

- étirement 3,6 suivant une direction 1 ou 2 située dans le plan de laminage,
- champ électrique appliqué suivant la direction 3, 100 kV,
- température de laminage 60° C, on obtient les valeurs suivantes :

|  | $d_{31}$ en pCN$^{-1}$ à 40 kHz | $E_1$ $10^9$ N/m$^2$ à 40 kHz | $\varepsilon\, r$ à 40 kHz | $g_{31}$ (0,1 V/m /Pa) à 40 kHz | $g_{31}/g_{31}$ PVF$_2$ à 1 kHz |
|---|---|---|---|---|---|
| 100 PVF$_2$ | 22,9 | 3,4 | 11 | 2,08 | 1 |
| 90 PVF$_2$ 10 PMMA | 19,4 | 3,6 | 8,5 | 2,28 | 1,25 |
| 75 PVF$_2$ 25 PMMA | 11,6 | 4,2 | 6,4 | 1,81 | |
| 70 PVF$_2$ 30 PMMA | 10,6 | 4,3 | 6 | 1,77 | |

D'après ce tableau, on constate que le module d'YOUNG dans la direction d'étirement $E_1$ croît régulièrement, que le coefficient piézoélectrique $d_{31}$ décroît régulièrement lorsque la concentration en PMMA dans l'alliage augmente. Cependant, puisque $\epsilon r$ varie dans le même sens, le

coefficient $g_{31} = \dfrac{d_{31}}{\epsilon r}$ passe par un maximum pour un alliage contenant entre 85 et 95 % de PMMA. Or, c'est ce coefficient qui intervient dans les calculs relatifs aux capteurs de type microphone. Ainsi, lorsque le $PVF_2$ et l'alliage 90 $PVF_2$ 10 PMMA ont été comparés lors de la réalisation de prototypes de microphones téléphoniques, on a constaté que l'alliage procurait une sensibilité à 1 kHz supérieure de 25 % par rapport au $PVF_2$.

Les alliages selon l'invention peuvent être utilisés pour pratiquement tous les types de transducteurs piézoélectriques, en particulier pour les capteurs de type microphone.

Tout ce qui a été dit sur les matériaux polymères piézoélectriques selon l'invention est bien sûr valable pour les matériaux polymères pyroélectriques. On peut donc les utiliser pour réaliser des dispositifs pyroélectriques.

Selon les applications envisagées, par un choix approprié des proportions des constituants d'un alliage, on peut chercher à privilégier les coefficients piézoélectriques $d_{ij}$ ou $g_{ij}$, à diminuer préférentiellement les pertes diélectriques, ou à obtenir la phase polaire sans avoir à modifier la forme géométrique d'un produit obtenu par moulage ou injection.

# REVENDICATIONS

1. Matériau présentant une phase polaire lorsqu'il se refroidit à pression ambiante à partir de l'état fondu, caractérisé en ce qu'il est un alliage d'au moins un premier et un second polymère ; ledit premier polymère étant un polymère piézoélectrique ou pyroélectrique dépourvu de phase polaire lorsqu'il se refroidit à pression ambiante à partir de l'état fondu ; ledit second polymère coopérant avec le premier polymère afin d'engendrer ladite phase polaire.

2. Matériau selon la revendication 1, caractérisé en ce que ledit premier polymère est le polyfluorure de vinylidène ($PVF_2$).

3. Matériau selon la revendication 2, caractérisé en ce que la concentration en poids dudit premier polymère dans le matériau est d'au moins 50 % et que ledit second polymère est le polyméthacrylate de méthyle (PMMA).

4. Matériau selon la revendication 3, caractérisé en ce que la concentration en poids dudit premier polymère dans le matériau est d'environ 75 %.

5. Matériau selon la revendication 3, caractérisé en ce que la concentration en poids dudit premier polymère dans le matériau est d'au moins 85 %.

6. Matériau selon l'une quelconque des revendications 1 à 5, caractérisé en ce qu'il a subi un recuit.

7. Transducteur électromécanique comportant un élément actif en polymère piézoélectrique, caractérisé en ce que ledit polymère est un matériau selon l'une quelconque des revendications 1 à 6.

8. Dispositif pyroélectrique comportant un élément actif en polymère pyroélectrique, caractérisé en ce que ledit polymère est un matériau selon l'une quelconque des revendications 1 à 6.

# FIG.1

FIG. 2

2/3

0093038

FIG.3

3/3

0093038

## RAPPORT DE RECHERCHE EUROPEENNE

Office européen
des brevets

EP   83  40  0762

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| A | EP-A-0 044 702  (MINNESOTA) <br> * Revendications 1,2,5,6; page 3, ligne 15 * | 1-3 | H 01 L   41/18 |
| | --- | | |
| A | CHEMICAL ABSTRACTS, vol. 85, no. 22, 29 novembre 1976, page 744, no. 170653n, Columbus, Ohio, USA & JP - A - 76 86798 (MATSUSHITA ELECTRIC INDUSTRIAL CO., LTD.) 29-07-1976 * Abrégé * | | |
| | ----- | | |

|  | DOMAINES TECHNIQUES RECHERCHES (Int. Cl. 3) |
|---|---|
| | H 01 L <br> C 08 L |

Le présent rapport de recherche a été établi pour toutes les revendications

| Lieu de la recherche | Date d'achèvement de la recherche | Examinateur |
|---|---|---|
| LA HAYE | 25-07-1983 | BOLETTI C.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 

& : membre de la même famille, document correspondant

OEB Form 1503. 03.82